# EUROPEAN PATENT APPLICATION

(11) **EP 1 387 490 A1**
(43) Date of publication of application: **04.02.2004**
(21) Application number: 03016350.5
(22) Date of filing: 18.07.2003
(51) Int. Cl.: H03K 3/84, G06F 7/58

(54) **Method for generating random number and random number generator**

(30) Priority: 30.07.2002 JP 2002221194; 07.11.2002 JP 2002323794
(71) Applicant: Niigata University, Niigata City, Niigata Pref., (JP)
(72) Inventor: Yoshiaki, Saito, Niigata City, Niigata Pref. (JP)
(74) Representative: von Hellfeld, Axel, Dr. Dipl.-Phys.

(57) **Abstract**

During the rise time from oscillation start to steady oscillation, an electronic signal is oscillated from an oscillating means and input into an A/D converter. Then, the electronic signal is converted into digital voltage components on the magnitude of the amplitude thereof. The digital voltage components are input in a personal computer which defines a threshold level for the digital voltage components. In the personal computer, the magnitude relation between the threshold level and the digital voltage components is judged, and numeral "0" or "1" is allotted to the digital voltage components on the magnitude relation, thereby to generate a binary random number.

## Description

### BACKGROUND OF THE INVENTION

### Field of the Invention

This invention relates to a method for generating random number and a random number generator which are usable in information industry field such as cryptograph, particularly in quantum computer field.

### Description of the related art

Random number which is perfectly in disorder and has uniform frequency of appearance is widely available in numerical simulation for social phenomenon, physical phenomenon and the like. The random number also plays an important role in cryptograph, and get a lot of attention in information security field. At present, various generating methods of random number are researched and developed, but can almost generate only pseudorandom number on software algorithm.

As of now, the algorithmic generating method of random number is widely available on a certain level of reliability and high speed random number generation. Generally, however, since the computer can generate only definite range of information, the random number generated by the computer has a given periodicity. Therefore, in numerical simulation, precise solution can not be obtained and in information security, sufficient security can not be realized.
In this point of view, random number with more perfect disorder is desired.

Recently, with the development of processing speed and reliability in hardware, a physical generating method of random number has been developed. For example, it is known that random number which is generated on physical phenomenon such as thermoelectron noise or radioactive decay has low predictability to be ideal. However, the physical generating method requires large scaled devices for generating the random number.

### SUMMERY OF THE INVENTION

It is an object of the present invention to provide, with simple and not expensive devices, a new method for generating random number with more perfectly disorder and a random number generator which is utilized in the generating method of random number.

For achieving the above object, this invention relates to a method for generating random number, comprising the steps of:
oscillating a given electronic signal,
defining a given threshold level for an amplitude of the electronic signal during a rise time from oscillation start to steady oscillation,
   and
allotting numeral "0" or "1" to amplitude levels of the electronic signal on magnitude relation utilizing the threshold level, thereby to generate a binary random number.

This invention also relates to a random number generator comprising:
an oscillating means to oscillate a given electronic signal,
   and
a calculating means to define a threshold level for an amplitude of the electronic signal and allot numeral "0" or "1" to amplitude levels of the electronic signal on magnitude relation utilizing the threshold level.

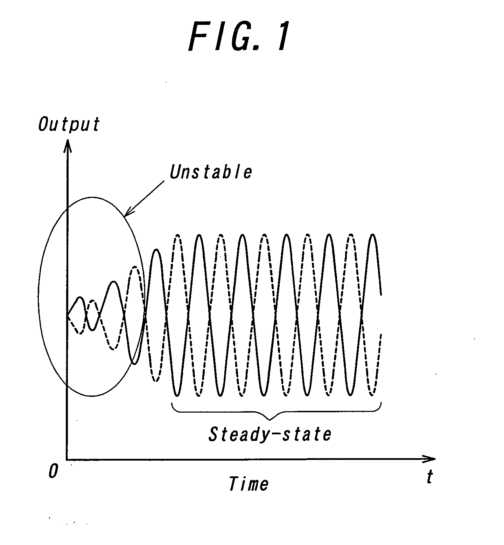

Fig. 1 is an explanatory view showing the principle of the generating method of random number of the present invention. When a given electronic signal is oscillated at a given frequency, as shown in Fig. 1, the frequency and the amplitude of the electronic signal becomes unstable due to the random noise of the oscillating circuit and the like during the rise time. Then, at the steady-state after a given period of time elapsed, the frequency and the amplitude of the electronic signal becomes stable. Therefore,.if a given threshold level is defined for the amplitude of the electronic signal during the rise time, and numeral "0" or "1" is allotted to the amplitude level on the threshold level of the electronic signal, a binary random number can be generated.

For example, numeral "1" is allotted to the amplitude level of the electronic signal larger than the threshold level, and numeral "0" is allotted to the amplitude level of the electronic signal smaller than the threshold level. As a result, the binary random number can be generated on the threshold level for the amplitude of the electronic signal.

In other words, according to the present invention, only if a generator with an oscillator to oscillate a given electronic signal and a calculating means to define a given threshold level for the amplitude of the electronic signal and allot numeral "0" or "1" on the amplitude level on the threshold level of the electronic signal is prepared, the binary random number with perfect disorder can be generated.

### BRIEF DESCRIPTION OF THE DRAWINGS

For better understanding of the present invention, reference is made to the attached drawings, wherein
Fig. 1 is an explanatory view showing the principle of a method for generating random number according to the present invention,
Fig. 2 is a structural view showing a preferred embodiment of a random number generator according to the present invention,
Fig. 3 is a circuit diagram of a preferred switching circuit in the random number generator shown in Fig. 2,
Fig. 4 is a circuit diagram of a preferred oscillating circuit in the random number generator shown in Fig. 2,
Fig. 5 is an explanatory view showing the principle for generating random number in the present invention,
Fig. 6 is an explanatory view showing the principle for not generating random number in the present invention,
Fig. 7 is a circuit diagram of another preferred oscillating circuit, and
Fig. 8 is a circuit diagram of still another preferred oscillating circuit.

### DESCRIPTION OF THE PREFERRED EMBODIMENTS

This invention will be described-in detail with reference to the accompanying drawings.

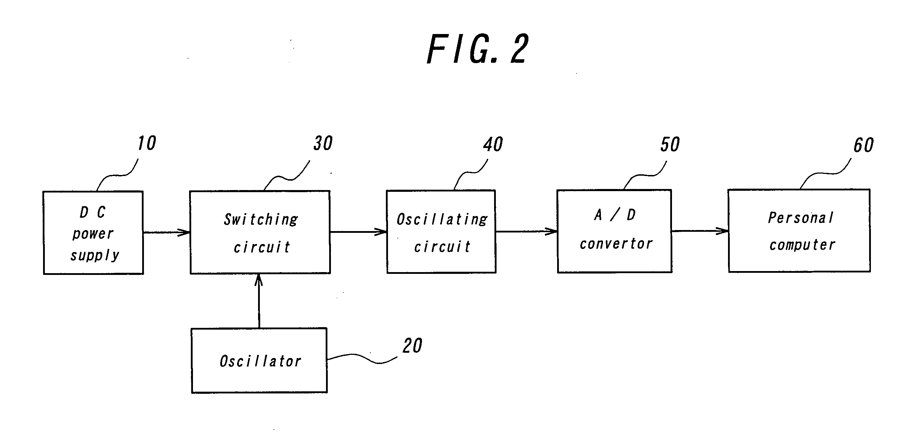

Fig. 2 is a structural view showing a preferred embodiment of a random number generator according to the present invention. In the random number generator illustrated in Fig. 2, a switching circuit 30, an oscillating circuit 40, an A/D converter 50, and a personal computer 60, which are connected in turn, are prepared. A DC power supply 10 and an oscillator 20 are connected to the switching circuit 30.

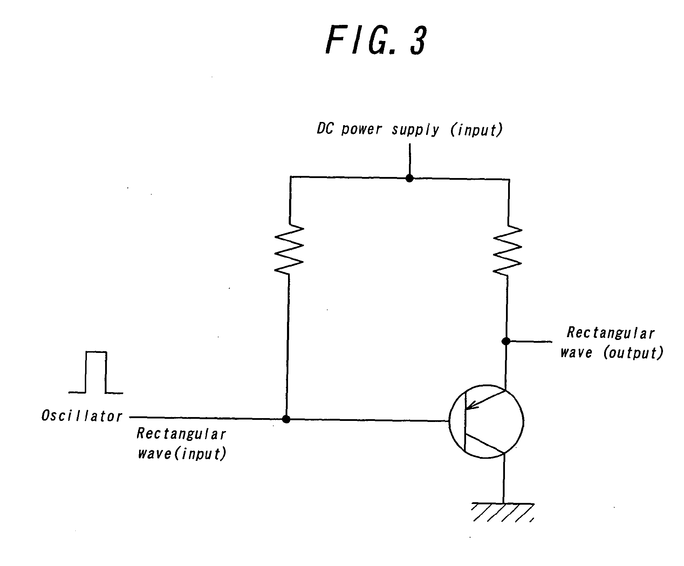

Fig. 3 is a circuit diagram of the switching circuit 30 in the random number generator shown in Fig. 2. In the switching circuit 30, a given DC voltage from the power supply 10 is modulated by a rectangular wave from the oscillator 20, and is output for the oscillating circuit 40.

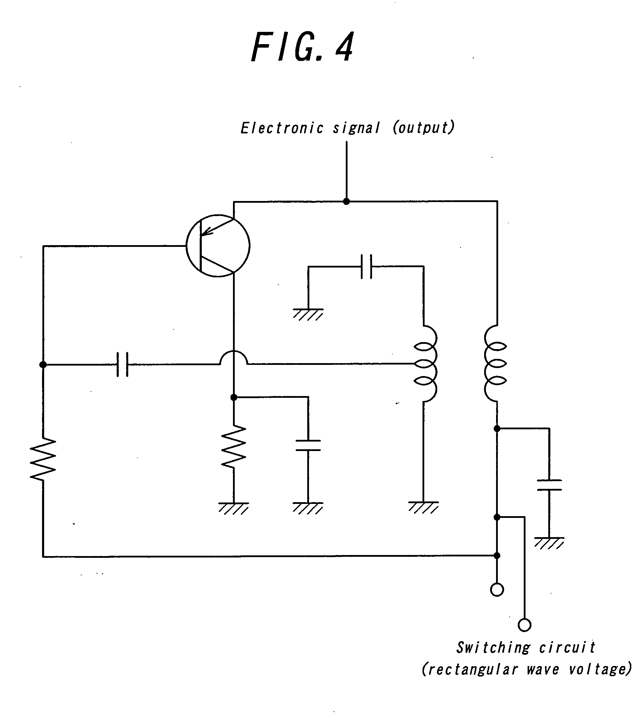

Fig. 4 is a circuit diagram of the oscillating circuit 40 in the random number generator shown in Fig. 2. In the oscillating circuit 40, the resultant rectangular DC voltage from the switching circuit 30 is intermittently oscillated as an electronic signal.

The electronic signal from the oscillating circuit 40 is input in the A/D converter 50, and converted into digital voltage components on the magnitude of the amplitude of the electronic signal. The digital voltage components are input into the personal computer 60, where a given threshold level is defined for the digital voltage components. Then, in the personal computer 60, the magnitude relation between the digital voltage components and the threshold level is judged, and numeral "0" or "1" is allotted to the digital voltage components, respectively on the magnitude relation.

At the initial oscillation stage, that is, the rise time from the oscillation start to the steady oscillation of the oscillating circuit 40, the frequency and the amplitude of the electronic signal becomes unstable due to the random noise of the oscillating circuit 40 and the like, as shown in Fig. 1. Therefore, if the electronic signal is employed only during the rise time, a binary random number of numerals "0" and "1" can be generated by the above-mentioned calculation utilizing the threshold level.

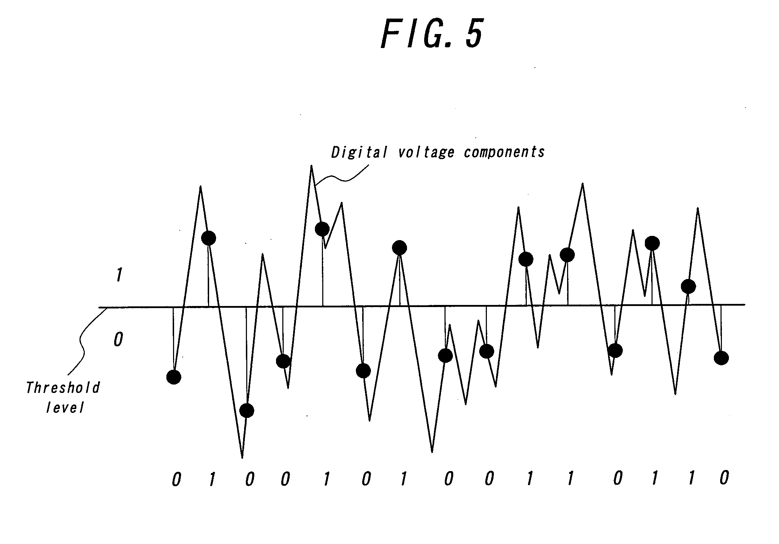

Fig. 5 is an explanatory view showing the principle for generating random number in the present invention. As shown in Fig. 5, if numeral "1" is allotted to the digital voltage components larger than the threshold level and numeral "0" is allotted to the digital voltage components smaller than the threshold level, the binary random number can be generated.

In the present invention, the switching circuit 30 is not essential, but can generate the rectangular DC voltage to be input into the oscillating circuit 40. According to the switching circuit 30, in this point of view, the electron signal can be intermittently oscillated from the oscillating circuit 40 as if the DC power supply is intermittently switched on and off. As a result, the random oscillation condition can be successively realized in the oscillating circuit 40 during the rise time.

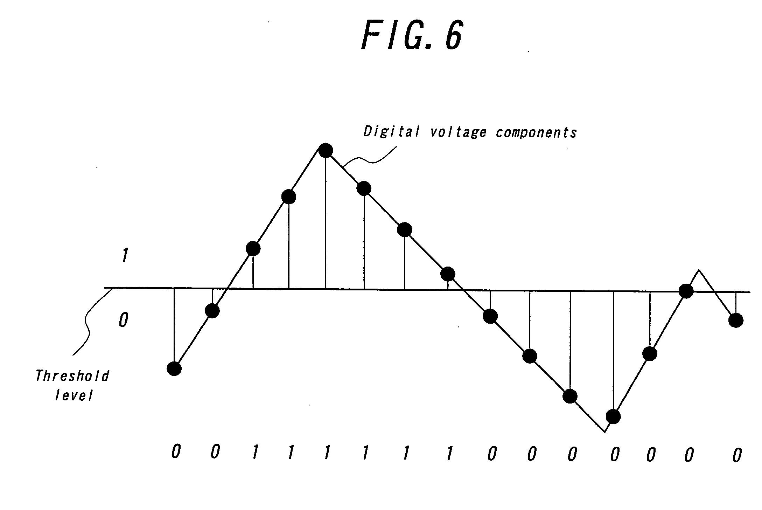

In the present invention, it is desired that the frequency of the electronic signal from the oscillating circuit 40 to be input into the A/D converter 50 is set higher than the sampling frequency. If the frequency of the electronic signal is set lower than the sampling frequency, for example, the electronic signal may be converted into the digital voltage components as shown in Fig. 6. In this case, even though a given threshold level is defined for the digital voltage components and numeral "0" or "1" is allotted to the digital voltage components on the magnitude relation between the threshold level and the digital voltage components, the numerals "0" or "1" are generated continuously to some degree. As a result, a random number can not be generated.

The intended random number can be generated at high speed as the sampling frequency is increased, so that if the frequency of the electronic signal can be increased by adjusting the capacitance and the inductance of the oscillating circuit 40 in Fig. 3, the binary random number can be generated stably at high speed.

Although the present invention was described in detail with reference to the above examples, this invention is not limited to the above disclosure and every kind of variation and modification may be made without departing from the scope of the present invention. For example, in order to obtain the rectangular DC voltage, although the switching circuit 30 shown in Fig. 3 is employed, the other well known means may be employed. Moreover, as the oscillation means of electronic signal, although the oscillating circuit 40 shown in Fig. 4 is employed, the other well known means may be employed.

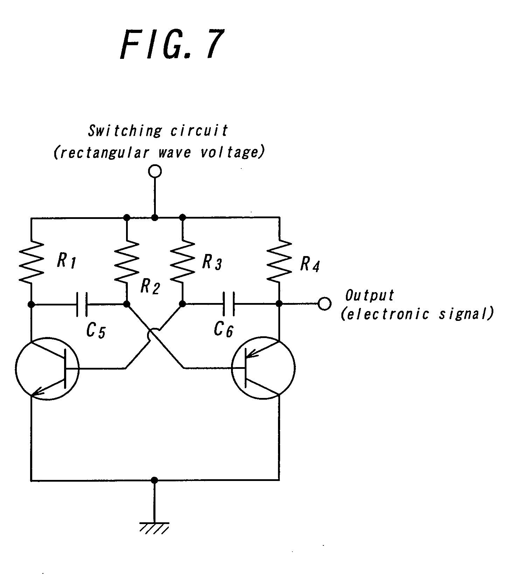

For example, an oscillating circuit of digital type may be employed, instead of the oscillating circuit 40 of analog type shown in Fig. 4. Fig. 7 is a circuit diagram of the oscillating circuit 40 of astable multivibrator type. When the rectangular DC voltage is input into the astable multivibrator type oscillating circuit 40 from the switching circuit 30, an electronic signal is intermittently oscillated from the oscillating circuit 40. Therefore, if the electronic signal is output from the oscillating circuit 40 and input into the A/D converter 50 and the personal computer 60, the digital voltage components of the electronic signal are converted into numeral "0" or "1" on the above-mentioned calculation, and thus, the intended binary random number can be generated.

In the present invention, two astable multivibrators may be employed. In this case, one is employed as a switching circuit, and the other is employed as an oscillating circuit. The two astable multivibrators are fabricated in the same chip which can be installed in the personal computer 60.

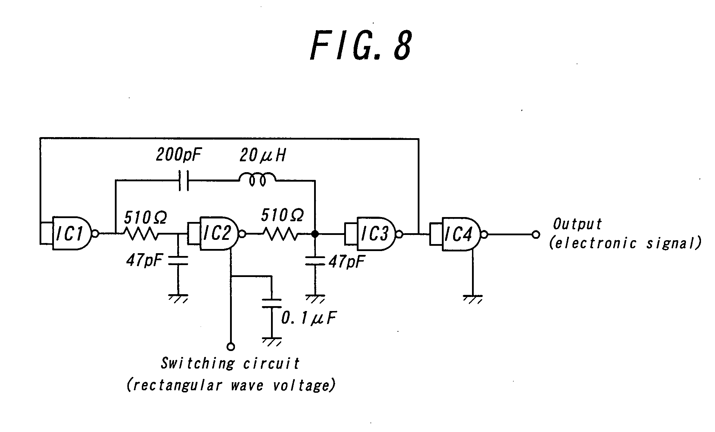

Fig. 8 is a circuit diagram of the oscillating circuit 40 of LC type utilizing digital ICs. In the oscillating circuit 40 shown in Fig. 8, four digital ICs are installed, and the inputs of the AND circuits in the left side IC1-IC3 are short-circuited and the oscillating circuit 40 is constructed as a positive feedback LC circuit. When a rectangular DC voltage is input into the oscillating circuit 40 from the switching circuit 30, an electronic signal is intermittently oscillated from the oscillating circuit 40. The AND circuit in the right side IC4 functions as a buffer, and the electronic signal from the oscillating circuit 40 is output from the IC4. Thereafter, the electronic signal is input into the A/D converter 50 and the personal computer 60. The digital voltage components of the electronic signal are converted into numeral "0" or "1" on the above-mentioned calculation, and thus, the intended binary random number can be generated.

The use of the LC oscillating circuit as shown in Fig. 8 can reduce the total cost of the random number generator, in comparison with the use of the astable multivibrator oscillating circuit as shown in Fig. 7 because high cost transistors are not employed.

When the digital oscillating circuit 40 as shown in Fig. 7 or 8 is employed, the A/D converter 50 may be removed. Therefore, the electronic signal from the oscillating circuit 40 is directly input into the personal computer 60. If a diode is added to the digital oscillating circuit 40 shown in Figs. 7 and 8, the wave form of the electronic signal can be improved during the rise time.

As mentioned above, according to the present invention, with simple and not expensive devices, a new method for generating random number with more perfectly disorder and a random number generator which is utilized in the generating method of random number can be provided.

## Claims

1. A method for generating random number, comprising the steps of:
oscillating a given electronic signal,
defining a given threshold level for an amplitude of said electronic signal during a rise time from oscillation start to steady oscillation,
and
allotting numeral "0" or "1" to amplitude levels of said electronic signal on magnitude relation utilizing said threshold level, thereby to generate a binary random number.

2. The generating method of random number as defined in claim 1, wherein said electronic signal is oscillated from a given oscillating circuit.

3. The generating method of random number as defined in claim 2, wherein a rectangular voltage is input into said oscillating circuit from a given switching circuit.

4. The generating method of random number as defined in claim 2 or 3, wherein said electronic signal is converted at a given A/D converter after oscillation from said oscillating circuit.

5. The generating method of random number as defined in claim 4, wherein a frequency of said electronic signal is set higher than a sampling frequency.

6. A random number generator comprising:
an oscillating means to oscillate a given electronic signal,
and
a calculating means to define a threshold level for an amplitude of said electronic signal and allot numeral "0" or "1" to amplitude levels of said electronic signal on magnitude relation utilizing said threshold level.

7. The random number generator as defined in claim 6, wherein said oscillating means includes a given oscillating circuit.

8. The random number generator as defined in claim 6 or 7, further comprising a rectangular wave-generating means in front of said oscillating means.

9. The random number generator as defined in claim 8, wherein said rectangular wave-generating means includes a switching circuit.

10. The random number generator as defined in any one of claims 6-9, further comprising an A/D converter in the rear of said oscillating means and in the front of said calculating means.
